Europäisches Patentamt

European Patent Office

Office européen des brevets

(11) Veröffentlichungsnummer: **0 052 221**
**B1**

(12) **EUROPÄISCHE PATENTSCHRIFT**

(45) Veröffentlichungstag der Patentschrift: **26.03.86**

(21) Anmeldenummer: **81108040.7**

(22) Anmeldetag: **07.10.81**

(51) Int. Cl.⁴: **G 01 R 19/165**

(54) **Schaltungsanordnung zur Auswertung von Signalen.**

(30) Priorität: **14.11.80 DE 3043053**

(43) Veröffentlichungstag der Anmeldung:
**26.05.82 Patentblatt 82/21**

(45) Bekanntmachung des Hinweises auf die
Patenterteilung:
**26.03.86 Patentblatt 86/13**

(84) Benannte Vertragsstaaten:
**AT BE CH FR GB IT LI NL SE**

(56) Entgegenhaltungen:
**FR-A-2 304 924**
**US-A-4 023 046**

(73) Patentinhaber: **Siemens Aktiengesellschaft**
**Berlin und München Wittelsbacherplatz 2**
**D-8000 München 2 (DE)**

(72) Erfinder: **Goerne, Jan, Dipl.-Ing.**
**Heinrich-Vogel-Strasse 8**
**D-8000 München 71 (DE)**
Erfinder: **Traulsen, Wilfried, Dipl.-Ing-**
**Karl-Marx-Ring 96**
**D-8000 München 83 (DE)**

Courier Press, Leamington Spa, England.

## Beschreibung

Die Erfindung bezieht sich auf eine Schaltungsanordnung zur Auswertung von Signalen entsprechend dem Oberbegriff des Patentanspruches.

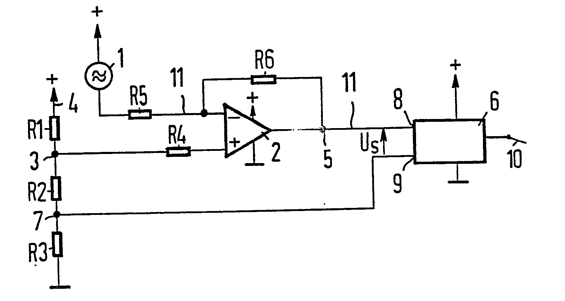

Eine solche Schaltungsanordnung ist aus der US—A—4023046, insbesondere Fig. 6 dieser Literaturstelle, bekannt. Dort wird zur Bildung des Referenzpotentials die Serienschaltung der ohmschen Widerstände von einem Strom durchflossen, der von einer Konstantstromquelle herrührt. Der erste der Serienschaltungswiderstände bildet dabei zusammen mit der Gate-Elektrode eines Feldeffekt-Transistors eine Regelschaltung, die den Widerstand der Source-Drain-Strecke des Transistors erhöht, wenn der Strom durch den Widerstand zunimmt und umgekehrt. Durch den zweiten Widerstand wird die Schwellenspannung des Komparators festgelegt, da der diesen Widerstand durchfließende Konstantstrom an diesem Widerstand einen bestimmten Spannungsabfall hervorruft. Diese Schaltung ist gegenüber Schwankungen der Betriebsspannungsquelle weitgehend unempfindlich und auch gegenüber temperaturbedingten Änderungen der Widerstandswerte relativ stabil, benötigt jedoch eine mit Hilfe eines Feldeffekt-Transistors realisierte Konstantstromquelle.

Aus der DE—B—2608206 ist es bekannt, den Abgriff eines einseitig an Masse liegenden ohmschen Spannungsteilers als einen das Referenzpotential für einen Komparator liefernden Schaltungspunkt vorzusehen.

Demgegenüber ist es Aufgabe vorliegender Erfindung, eine Schaltungsanordnung der eingangs genannten Art so auszubilden, daß bei geringem Schaltungsaufwand eine hohe Stabilität der Schwellenspannung des Komparators erzielt wird.

Erfindungsgemäß ergibt sich die Lösung dieser Aufgabe durch eine den kennzeichnenden Merkmalen des Patentanspruches entsprechende Ausbildung einer solchen Schaltungsanordnung.

Infolge der niederohmigen Bemessung des die Abgriffe trennenden Widerstandes im Verhältnis zur Hochohmigkeit des gesamten Spannungsteilers bleiben die Potentialverhältnisse an den beiden Eingängen des Komparators auch bei relativ schwankender Spannung der Spannungsquelle stabil. Dadurch wird aber vorteilhaft sichergestellt, daß die Signalauswertung weitgehend unabhängig von der in gewisem Ausmaß schwankenden Spannung der Spannungsquelle, von den verwendeten Halbleiterbauelementen und von Temperatureinflüssen ist. Dies ermöglicht es, die Spannungsschwelle am Komparator sehr niedrig zu machen und dadurch eine maximale Empfindlichkeit der Signalauswerteschaltungsanordnung zu erzielen.

Ein Ausführungsbeispiel der Erfindung wird nachfolgend anhand von einer Figur noch näher erläutert.

Die Figur zeigt in schematischer Darstellung, unter Weglassung aller nicht unbedingt zum Verständnis des Erfindungsgegenstandes erforderlichen Einzelheiten, im Rahmen eines Schaltbildes, eine Signalquelle 1, die einen relativ sehr hohen Innenwiderstand R5, der gesondert eingezeichnet ist, aufweist und die einerseits an dem von Masse abgewandten Pol einer nichtdargestellten Speisespannungsquelle liegt, andererseits mit dem invertierenden Eingang (—) eines Operationsverstärkers 2 verbunden ist.

Der Operationsverstärker 2 wird von einer einseitig an Masse liegenden Spannungsquelle gespeist, die dieselbe ist, an welche auch die Signalquelle 1 angeschlossen ist. Die Spannungsquelle gibt z.B. eine Spannung von 5 V ab und ist mit ihrem Minuspol mit Masse verbunden.

Der nichtinvertierende Eingang (+) des Operationsverstärkers 2 ist über einen ohmschen Widerstand R4 mit dem vom masseseitigen Ende entfernteren Abgriff 3 eines aus drei in Serie geschalteten ohmschen Widerständen R1, R2, R3 gebildeten Spannungsteilers 4 verbunden, wobei der Spannungsteiler 4 ebenfalls an der einseitig an Masse liegenden Speisespannungsquelle liegt.

Zwischen dem Ausgang 5 des Operationsverstärkers 2 und dessen invertierendem Eingang (—) ist ein Rückkopplungswiderstand R6 angeordnet, dessen Wert dem des Widerstands R4 entspricht. Dadurch ergibt sich eine symmetrische Betriebsweise des Operationsverstärkers gegenüber dem ausgangsseitigen Ruhepegel.

Der Ausgang 5 des Operationsverstärkers 2 ist an einen der beiden Eingänge 8, 9 nämlich den Signaleingang 8, eines Komparators 6 angeschlossen, dessen anderer Eingang (Referenzeingang) an dem Abgriff 7, also an dem anderen Abgriff, des Spannungsteilers 4 liegt. Der Komparator wird ebenfalls von der nichtdargestellten Betriebsspannungsquelle gespeist.

Der zwischen den Abgriffen 3, 7 angeordnete Widerstand R2 ist relativ niederohmig gegenüber dem ingesamt hochohmigen Spannungsteiler. Auf diese Weise ist der Spannungsabfall am Widerstand R2 auch bei nur geringer Konstanz der Spannung der Speisespannungsquelle weitgehend stabil.

Bei fehlendem Signal auf der von der Signalquelle 1 zum invertierenden Eingang (—) verlaufenden Signalleitung 11 (Signalstrom $\cong$ 0), ist das Potential am Ausgang 5 des Operationsverstärkers 2 im wesentlichen gleich dem Potential des Abgriffes 3 des Spannungsteilers 4. Dieses Potential liegt daher auch am Signaleingang 8 des Komparators 6.

Der Referenzeingang 9 des Komparators weist dagegen das Potential des Abgriffes 7 des Spannungsteilers 4 auf. Durch geeignete Bemessung des Widerstandes R2 erhält man daher zwischen den beiden Eingängen des Komparators eine Potentialdifferenz, die die Schwellenspannung des Komparators definiert.

Ein von der Signalquelle 1 abgegebenes Signal schwimmt quasi auf dem Potential des Abgriffes 3 des Spannungsteilers 4, so daß infolge der stabilen Schwellenspannung des Komparators 6 jedes von der Signalquelle 1 herrührende Signal einen diese Schwellenspannung von z.B. 60 mV überwindenden Mindestpegel aufweisen muß, um das Ausgangssignal des Komparators umzuschalten. Wegen der großen Stabilität der Spannungsdifferenz zwischen den Abgriffen 3, 7 des Spannungsteilers 4 kann die Schwellenspannung sehr gering bemessen werden, so daß die Signalauswerteschaltungsanordnung eine extreme Empfindlichkeit besitzt.

Die jeweilige Dauer eines von der Signalquelle 1 herrührenden Signales spielt dabei keine Rolle. Der Ausgang 10 des Komparators 6 geht jeweils für die Dauer eines Signales auf der Signalleitung 11 von einem ersten in einen zweiten Potentialzustand über, der damit das Vorliegen eines Signales anzeigt.

Bei einem typischen Ausführungsbeispiel wurden folgende Widerstandswerte bzw. Bauelemente verwendet. R1 ~ 510 $\Omega$; R2 ~ 27 $\Omega$; R3 ~ 750 $\Omega$; R4 ~ 100 k$\Omega$; R5 ~ 1 M$\Omega$; R6 ~ 100 k$\Omega$; Bauelement 2 (Operationsverstärker) (TCA 325 der Firma Siemens; Bauelement 6 (Komparator) LM 311 der Firma Texas Instruments; Bauelement 1 (Signalquelle) SFH 202 der Firma Siemens.

Bezugszeichenliste
  1 Signalquelle
  2 Operationsverstärker
  3 Abgriff am Spannungsteiler
  4 Spannungsteiler
  5 Ausgang des Operationsverstärkers
  6 Komparator
  7 Abgriff am Spannungsteiler
  8, 9 Eingänge des Komparators
  10 Ausgang des Komparators
  11 Signalleitung
  R1, R2, R3 Spannungsteilerwiderstände
  R4 Vorwiderstand des nichtinvertierenden Eingangs des Operationsverstärkers
  R5 Innenwiderstand der Signalquelle
  R6 Gegenkopplungswiderstand am Operationsverstärker

**Patentanspruch**

Schaltungsanordnung zur Auswertung von Signalen, mit einem Komparator (6), an dessen einen Eingang (8) eine die Signale führende Signalleitung (11) angeschlossen ist und dessen anderer Eingang (9) mit einem Abgriff (7) einer einseitig an Masse liegenden Serienschaltung von drei ohmschen Widerständen (R1, R2, R3) verbunden ist, und mit einem in die Signalleitung (11) vor dem Komparator (6) eingefügten, ebenso wie der Komparator als Operationsverstärker ausgebildeten und zusammen mit dem Komparator (6) und der Serienschaltung ohmscher Widerstände (R1, R2, R3) von lediglich einer Spannungsquelle gespeisten Verstärker (2), dessen nichtinvertierender Eingang (+) mit einem weiteren Abgriff (3) der Serienschaltung ohmscher Widerstände und dessen invertierénder Eingang (−) mit der Signalleitung (11) verbunden ist, wobei der zwischen den beiden Abgriffen (3, 7) liegende ohmsche Widerstand (R2) die Schwellenspannung des Komparators (6) festlegt, dadurch gekennzeichnet, daß die Serienschaltung ohmscher Widerstände (R1, R2, R3) ein auf einer Seite an den von Masse abgewandten Pol der Spannungsquelle angeschlossener Spannungsteiler (4) ist, und daß das Verhältnis des Widerstandswertes des zwischen den Abgriffen (3, 7) angeordneten Widerstandes (R2) zu der Summe der Widerstandswerte der anderen beiden Spannungsteilerwiderstände (R1, R3) in der Größenordnung von ungefähr 1 zu 50 liegt.

**Revendication**

Montage pour exploiter des signaux, comportant un comparateur (6), à une entrée (8) duquel se trouve raccordée une ligne de transmission de signaux (11) transmettant les signaux et dont l'autre entrée (9) est reliée à une prise (7) d'un circuit série, dont une borne est raccordée à la masse et qui comporte trois résistances ohmiques (R1, R2, R3), et comportant un amplificateur (2) inséré en amont du comparateur (6) dans la ligne de transmission de signaux (11), réalisé sous la forme d'un amplificateur opérationnel, et alimenté, de même que le comparateur ainsi que le comparateur (6) et le circuit série formé des résistances ohmiques (R1, R2, R3), par une seule source de tension, et dont l'entrée non inverseuse (+) est reliée à une autre prise (3) du circuit série formé des résistances ohmiques et dont l'entrée inverseuse (−) est reliée à la ligne de transmission de signaux (11), la résistance ohmique (2) montée entre les deux prises (3, 7) déterminant la tension de seuil du comparateur (6), caractérisé par le fait que le circuit série formé des résistances ohmiques (R1, R2, R3) est un diviseur de tension (4) dont une borne est raccordée au pôle, opposé à la masse, de la source de tension, et que le rapport de la valeur résistive de la résistance (R2), montée entre les prises (3, 7), à la somme des valeurs résistives des deux autres résistances (R1, R3) du diviseur de tension est d'un ordre de grandeur compris entre environ 1 et 50.

**Claim**

A circuit arrangement for the interpretation of signals, having a comparator (6), with one input (8) connected to a signal-carrying signal line (11) and its other input (9) connected to a tapping (7) on a series cascade of three resistors (R1, R2, R3), which is connected to earth at one end, and having an amplifier (2) in the form of an operational amplifier similar to the comparator inserted into the signal line (11) preceding the comparator (6), and fed from one voltage source together with the comparator (6) and the series cascade of resistors (R1, R2, R3), whose noninverting input (+) is connected to a further tapping (3) of the series cascade of resistors and whose inverting input (−) is connected to the signal line (11), where the resistor (R2) arranged between the two tappings (3, 7) determines the threshold voltage of the comparator (6), characterised in that the series cascade of resistors (R1, R2, R3) is a voltage divider (4) connected on one side to the pole of the voltage source remote from earth, and that the ratio of the resistance of the resistor (R2) arranged between the tappings (3, 7) to the sum of the resistances of the other two voltage divider resistors (R1, R3) is in the range of approximately 1 to 50.

4